(19) Europäisches Patentamt
European Patent Office
Office européen des brevets

(11) **EP 2 332 252 B1**

(12) **EUROPÄISCHE PATENTSCHRIFT**

(45) Veröffentlichungstag und Bekanntmachung des Hinweises auf die Patenterteilung:
**29.08.2018 Patentblatt 2018/35**

(51) Int Cl.:
***H03F 1/52*** *(2006.01)*     ***H01R 3/00*** *(2006.01)*
***H03G 7/08*** *(2006.01)*     ***H04R 3/00*** *(2006.01)*

(21) Anmeldenummer: **09782392.6**

(22) Anmeldetag: **31.08.2009**

(86) Internationale Anmeldenummer:
**PCT/EP2009/061201**

(87) Internationale Veröffentlichungsnummer:
**WO 2010/034589 (01.04.2010 Gazette 2010/13)**

(54) **AUDIOVERSTÄRKER MIT LASTANPASSUNG SOWIE VERFAHREN ZUR LASTANPASSUNG DES AUDIOVERSTÄRKERS**

AUDIO AMPLIFIER COMPRISING MATCHING OF LOAD AND METHOD OF MATCHING THE LOAD TO THE AUDIO AMPLIFIER

AMPLIFICATEUR AUDIO COMPRENANT UNE ADAPTATION DE CHARGE ET METHODE D'ADAPTATION DE CHARGE À CET AMPLIFICATEUR AUDIO

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **25.09.2008 DE 102008042377**

(43) Veröffentlichungstag der Anmeldung:
**15.06.2011 Patentblatt 2011/24**

(73) Patentinhaber: **Robert Bosch GmbH**
**70442 Stuttgart (DE)**

(72) Erfinder:
• **TAFFNER, Josef**
**93093 Donaustauf (DE)**
• **SAUER, Gregor**
**35510 Butzbach-Griedel (DE)**
• **GLUECK, Christian**
**Eden Prairie**
**55346 (US)**
• **PLAGER, Josef**
**94327 Bogen (DE)**
• **HALLSTEIN, Peter**
**64291 Darmstadt (DE)**

(56) Entgegenhaltungen:
**EP-A1- 0 762 633**     **EP-A1- 0 762 633**
**WO-A2-2004/023631**     **WO-A2-2004/023631**

**Beschreibung**

Stand der Technik

Die Erfindung betrifft einen Audioverstärker zur Verstärkung eines Eingangssignals in ein Ausgangssignal mit einer Ausgangsverstärkerstufe, wobei die Ausgangsverstärkerstufe zur Verstärkung eines Zwischensignals in das Ausgangssignal als ein im Schaltbetrieb arbeitender Verstärker ausgebildet ist. Im Weiteren betrifft die Erfindung ein Verfahren zur Lastanpassung des Audioverstärkers.

Audioverstärker werden zur Verstärkung eines Eingangssignals in ein Ausgangssignal eingesetzt, wobei das Ausgangssignal meist über Lautsprecher akustisch in die Umgebung abgestrahlt wird. Audioverstärker sind z. B. in sogenannten Heimstereoanlagen oder Beschallungsanlagen für Diskotheken, Kinosäle etc. oder auch für öffentliche Gebäude, Schulen, Universitäten etc. zur Verbreitung von Durchsagen bekannt.

Die Anzahl, die Lastimpedanz und die elektrische Belastbarkeit der von üblichen Audioverstärkern signaltechnisch versorgten Lautsprecher können nahezu beliebig variieren. Um jeder Konfiguration einen hinsichtlich der Gesamtlastimpedanz und der gewünschten Ausgangsleistung abgestimmten Audioverstärker bieten zu können, ist es üblich, unterschiedliche Audioverstärkermodelle mit diskret abgestufter Ausgangsleistung auf dem Markt anzubieten.

Das Dokument WO 2004/023631 offenbart einen geschalteten Verstärker, der abhängig von der Eingangsspannung und der Speisespannung die Verstärkung so einstellt, dass keine Verzerrungen auftreten.

Das Dokument EP 0762633 A1, die wohl den nächstkommenden Stand der Technik bildet, betrifft einen analogen Verstärker zur Verstärkung eines Eingangssignals mit einer Ausgangsverstärkerstufe, wobei das Eingangssignal vor der Ausgangsverstärkungsstufe über eine Limiterspannung von einer Limitereinrichtung derart begrenzt wird, dass eine Maximalausgangsleistung der Ausgangsverstärkerstufe nicht überschritten wird. Bei einer Änderung der Maximalausgangsleistung soll wahlweise die Limitereinrichtung ausgetauscht werden oder die Limiterspannung irgendwie begrenzt werden.

Offenbarung der Erfindung

Die Erfindung offenbart einen Audioverstärker mit den Merkmalen des Anspruchs 1 sowie ein Verfahren mit den Merkmalen des Anspruchs 7. Bevorzugte oder vorteilhafte Ausführungsformen der Erfindung ergeben sich aus den Unteransprüchen, der nachfolgenden Beschreibung sowie den beigefügten Figuren.

Der erfindungsgemäße Audioverstärker ist zur Verstärkung eines Eingangssignals in ein Ausgangssignal geeignet und/oder ausgebildet. Der Audioverstärker kann beispielsweise in Musikanlagen oder - bevorzugt - in Beschallungsanlagen, insbesondere bei Public-Adress-Systemen zur Beschallung von komplexen Bereichen eingesetzt werden. Der Audioverstärker ist insbesondere als eine niederohmige gesteuerte Spannungsquelle ausgebildet. Das Ausgangssignal des Audioverstärkers ist vorzugsweise als das Signal definiert, welches an elektromechanische Schallwandler und/oder Lautsprecher ausgegeben wird. Das Eingangssignal ist bevorzugt als ein analoges Signal ausgebildet, welches beispielsweise von einem Mikrofon oder einer anderen Audioquelle stammt.

Der Audioverstärker umfasst neben weiteren, optionalen Komponenten mindestens eine Ausgangsverstärkerstufe, welche zur Verstärkung eines Zwischensignals in das Ausgangssignal geeignet und/oder ausgebildet ist. Das Zwischensignal ist insbesondere als ein auf Basis des Eingangssignals erzeugtes Signal ausgebildet.

Die Ausgangsverstärkerstufe ist als ein im Schaltbetrieb arbeitender Verstärker realisiert, insbesondere als ein Verstärker, welcher ein pulsweitenmoduliertes Signal, das auf Basis des Eingangssignals und/oder des Zwischensignals erzeugt ist bzw. dieses repräsentiert, verstärkt.

Im Rahmen der Erfindung wird vorgeschlagen, eine Begrenzereinrichtung in den Audioverstärker zu integrieren, welche programmtechnisch und/oder schaltungstechnisch ausgebildet ist, auf Basis des Eingangssignals das Zwischensignal zu erzeugen, wobei der Pegel des Zwischensignals in Abhängigkeit einer stellbaren Maximalleistung und einer an den Audioverstärker angekoppelten und/oder ankoppelbaren Lastimpedanz oder - alternativ dazu - äquivalenter Parametergrenzen stets derart unter einem Maximalpegel liegt, so dass das Ausgangssignal unabhängig vom Eingangssignal die Maximalleistung bei eben dieser Lastimpedanz bzw. die äquivalenten Parametergrenzen nicht überschreitet. Die Begrenzereinrichtung begrenzt das Zwischensignal bevorzugt nur dann, wenn dadurch die durch die Ausgangsspannung erzeugte Leistung über der eingestellten oder programmierten Ausgangsleistung liegen würde.

Es ist dabei eine Überlegung der Erfindung, einen Audioverstärker vorzuschlagen, welcher flexibel an verschiedene Lastimpedanzen anpassbar ist. Üblicherweise ist die praktisch erreichbare Ausgangsleistung eines Audioverstärkers maßgeblich von drei Faktoren abhängig: Von der internen Betriebsspannung $U_0$ der Ausgangsverstärkerstufe, von der maximalen Stromtragfähigkeit $I_P$, der Ausgangsverstärkerstufe und von der Impedanz der Last (z.B. der Impedanz der Lautsprecher) $R_{LSP}$.

Die maximale Ausgangsleistung eines herkömmlichen Audioverstärkers wird bei der niedrigsten Impedanz $R_{LSP}$ erreicht, bei der die Endstufe gerade an der Grenze der Stromtragfähigkeit $I_P$ arbeitet. Dies bedeutet aber im Umkehrschluss, dass bei höheren Impedanzen die Endstufe bezüglich der Ausgangsleistung nicht voll ausgenutzt werden kann. Der Verstärker, insbesondere das Netzteil des Verstärkers, ist in diesem Fall überdimensioniert. Um diesen Nachteil zu umgehen, werden üblicherweise unterschiedliche Verstärkermodelle mit diskret abgestufter Ausgangsleistung angeboten.

Der erfindungsgemäße Audioverstärker ist dagegen so aufgebaut, dass er eine maximale und/oder eine gewünschte bzw. vorgebbare Ausgangsleistung - nachfolgend auch zusammenfassend Maximalausgangsleistung genannt - in weiten Leistungsbereichen bei beliebigen Lastimpedanzen abgeben kann. Mit Hilfe der vorliegenden Erfindung ist es somit möglich, Audioverstärker zu bauen, die bezüglich der Ausgangsleistung, insbesondere der Maximalausgangsleistung, in weiten Bereichen variiert werden können. Dabei ist zum Beispiel keine Umschaltung der internen Versorgungsspannung nötig, was den konstruktiven Aufwand des Verstärkers vereinfacht. Die Erfindung beschränkt sich nicht auf bestimmte, diskrete Ausgangsleistungen, bevorzugt kann die Ausgangsleistung stufenlos eingestellt werden.

Optional nutzbare Vorteile der Erfindung sind:

- Die maximale erreichbare Ausgangsleistung des Verstärkers kann in weiten Bereichen in jede gewünschte Lastimpedanz abgegeben werden;

- Die Ausgangsleistung des Verstärkers kann bei einer vorgegebenen Lastimpedanz in weiten Bereichen frei eingestellt werden. Dadurch entfällt in manchen Fällen die Notwendigkeit, Verstärker unterschiedlicher Leistungsklassen vorhalten zu müssen, der Verstärker kann flexibel an den jeweiligen Anwendungsfall angepasst werden.

- Bei einer möglichen Erfindungsausbildung für Mehrweganlagen (zum Beispiel Verstärkermodule für Aktivboxen) kann die Ausgangsleistung für verschiedene Wege nahezu unabhängig voneinander beliebig variiert werden, ohne dass unterschiedliche Betriebsspannungen für die einzelnen Verstärkerkanäle vorgehalten werden müssen. Beispielsweise ist es oft sinnvoll, die Leistung auf den Mittenfrequenz- und Hochtonfrequenzbereichen niedriger zu wählen, als die Leistung des Tieffrequenzweges, da dies der typischen Leistungsverteilung über die Frequenz von Sprach- und Musiksignalen entspricht bzw. da die elektrische Belastbarkeit von Basslautsprechern typischerweise deutlich höher ist als die von Mitten- und Hochtonlautsprechern;

- Bei einer möglichen Erfindungsausbildung als Mehrkanalverstärker können kanalweise je auf eine beliebige unterschiedliche Ausgangsleistung an einer in weiten Bereichen beliebigen Lastimpedanz eingestellt werden. In der Praxis bildet dabei die von dem Netzteil zur Verfügung gestellte Leistung eine Obergrenze für die Gesamtleistung aller Kanäle;

- Als Schutz vor Überlastung der angeschlossenen Lautsprecher kann mit Hilfe der Begrenzereinrichtung - gegebenenfalls temporär oder dauerhaft - eine beliebige Reduktion der Ausgangsleistung erfolgen bzw. eingestellt werden;

- Bei Verstärkern gemäß dieser Erfindung entfällt optional die Notwendigkeit der Verwendung externer Limiter, um die Ausgangsleistung des Audioverstärkers zu begrenzen, da diese Funktion von der Begrenzereinrichtung übernommen wird.

Bei einer sehr praxisnahen Ausführung der Erfindung ist die Begrenzereinrichtung ausgebildet, den Pegel des Zwischensignals in Abhängigkeit einer stellbaren Maximalleistung und einer an den Audioverstärker angekoppelten und/oder ankoppelbaren Lastimpedanz unter den Maximalpegel zu begrenzen. Nachdem jedoch die Ausgangsspannung der Ausgangsverstärkerstufe $U_{out}$, die Ausgangsleistung $P_{out}$ und die Lastimpedanz $R_{LSP}$ über die Gleichung

$$U_{out} = \sqrt{P_{out} \cdot R_{LSP}}$$

verknüpft sind, können alternativ die Eingangsparameter Ausgangsspannung und Lastimpedanz oder Ausgangsspannung und Ausgangsleistung verwendet werden. Im Rahmen der Erfindung ist eine Steuereinheit vorgesehen, welche zur Übernahme von Werten für die anliegende Lastimpedanz und stellbare Maximalleistung ausgebildet ist. Die Eingabe der Werte in die Steuereinheit erfolgt über eine Übergabeeinrichtung, welche eine manuelle Eingabe der benötigten Werte erlaubt. Die Eingabe kann beispielsweise in Form von analogen oder digitalen Werten umgesetzt sein. Bei einer möglichen Ergänzung der Erfindung ist die Übergabeeinrichtung zur automatischen Ermittlung der an dem Audioverstärker anliegenden Lastimpedanz und/oder der Ausgangsleistung und/oder der Ausgangsspannung ausgebildet. Die automatisch ermittelten Werte können statt und/oder ergänzend zu den manuell eingegebenen Werten an die Steuereinheit übergeben werden und zur Steuerung der Begrenzereinrichtung genutzt werden.

Bei einer bevorzugten Ausführungsform ist die Ausgangsverstärkerstufe mit nur einer einzigen bipolaren Spannungsversorgung versorgt und/oder als Class-D-Verstärker und/oder mit einer konstanten Verstärkung ausgebildet. Diese bevorzugte Ausführungsform unterstreicht den Vorteil der Erfindung, einen Audioverstärker mit einer kostengünstigen Schaltung darstellen zu können. Die Ausbildung der Ausgangsverstärkerstufe als Class-D-Verstärker und/oder mit einer konstanten Verstärkung basiert darauf, dass derartige Verstärker über weite Bereiche des Eingangspegels des Zwischensignals einen konstant hohen Wirkungsgrad zeigen.

Bei einer Weiterbildung der Erfindung umfasst die Begrenzereinrichtung eine Analysatoreinheit und eine Limitereinheit, wobei die Analysatoreinheit auf Basis eines anliegenden Audioträgersignals und des Maximalpegels ein Begrenzungssignal an die Limitereinheit ausgibt und/oder rückkoppelt. Das Audioträgersignal kann als das Eingangssignal, oder als ein bereits weiterverarbeitetes Signal ausgebildet sein. Analysatoreinheit und Limitereinheit bilden einen Regelkreis, wobei die Regelung so ausgestaltet ist, dass das Zwischensignal den Maximalpegel im Kleinsignalbereich nicht überschreitet.

Hierbei kann die Limitereinheit als eine Vorverstärkungseinrichtung, deren Verstärkung in Abhängigkeit des rückgekoppelten Begrenzungssignals eingestellt wird, und/oder als eine Dämpfungseinrichtung ausgebildet sein, welche auf Basis des rückgekoppelten Begrenzungssignals das anliegende Audioträgersignal dämpft. Optional kann die Analysatoreinheit ebenfalls als eine Begrenzerschaltgruppe ausgebildet sein, so dass die Begrenzereinrichtung die Begrenzung in zwei Stufen umsetzt, wobei in der ersten Stufe - in der Limitereinheit - eine Verstärkung und in der zweiten Stufe - in der Analysatoreinheit - eine Dämpfung gesteuert oder geregelt wird.

Bei einer möglichen Ausführungsform ist die Begrenzereinrichtung der Ausgangsverstärkerstufe vorgeschaltet und analysiert beziehungsweise begrenzt das analoge Audioträgersignal und bildet auf diese Weise das Zwischensignal. Bei einer alternativen Ausführungsform der Erfindung ist die Begrenzereinrichtung schaltungstechnisch so integriert, dass zunächst das Audioträgersignal pulsweitenmoduliert wird und dann das pulsweitenmodulierte Audioträgersignal begrenzt wird und damit das Zwischensignal bildet.

Bei einer Weiterführung der Erfindung weist der Audioverstärker eine Eingangsverstärkereinrichtung auf, welche zur Konditionierung des Eingangssignals, insbesondere zur Anpassung der Eingangsimpedanz und des Eingangspegels ausgebildet ist. Optional umfasst der Audioverstärker noch eine Levelstellereinrichtung zur Anpassung der Lautstärke und/oder der Verstärkung. Die Levelstellereinrichtung ist vorzugsweise so verschaltet, dass diese im Kleinsignalbereich auf das Audioträgersignal wirkt.

Obwohl vorliegend die Erfindung nur anhand einer Ausgangsverstärkerstufe und einer Begrenzereinrichtung beschrieben wurde, ist es im Rahmen der Erfindung, dass der Audioverstärker mehrere Kanäle aufweist, welche jeweils eine Ausgangsverstärkerstufe zeigen, die einer oder mehrerer Begrenzereinrichtungen zugeordnet sind, wobei die Begrenzereinrichtungen durch unterschiedliche Maximalpegel die Begrenzung umsetzen können. Mit einem derartigen mehrkanaligen Audioverstärker ist es möglich, einen Mischbetrieb zwischen Lautsprecherkonfigurationen mit verschiedenen Lastimpedanzen zu fahren und auf diese Weise ausgehend von einer einzigen Audioverstärkerbauweise unterschiedliche Lastimpedanzen mit einer Maximalausgangsleistung und/oder einer gewählten Maximalausgangsleistung selektiv zu beaufschlagen. Bei einer Umkonfiguration muss nur die Lastimpedanz bzw. die maximale Ausgangsleistung bzw. die äquivalenten Grenzparameter umgestellt werden.

Ein weiterer Gegenstand der Erfindung betrifft ein Verfahren zur Umkonfiguration eines Audioverstärkers, vorzugsweise nach einem der vorhergehenden Ansprüche, welches durch die Schritte gekennzeichnet ist: Trennen eines ersten Lautsprechersystems mit einer ersten Lastimpedanz von dem Audioverstärker, Umstellen der Maximalausgangsleistung des Audioverstärkers von einem ersten Wert auf einen zweiten Wert und optional der Lastimpedanz, Anschließen eines zweiten Lautsprechersystems mit einer zweiten Lastimpedanz, wobei die erste und die zweite Lastimpedanz unterschiedlich ausgebildet sind.

Kurze Beschreibung der Zeichnungen

Weitere Merkmale, Vorteile und Wirkung der Erfindung ergeben sich nachfolgenden Beschreibung eines bevorzugten Ausführungsbeispiels der Erfindung sowie den beigefügten Figuren. Dabei zeigen:

Figur 1　　ein Blockdiagramm eines Audioverstärkers gemäß der Erfindung;

Figur 2　　ein Blockschaltbild der Analysatoreinheit in dem Audioverstärker in der Figur 1.

Ausführungsform(en) der Erfindung

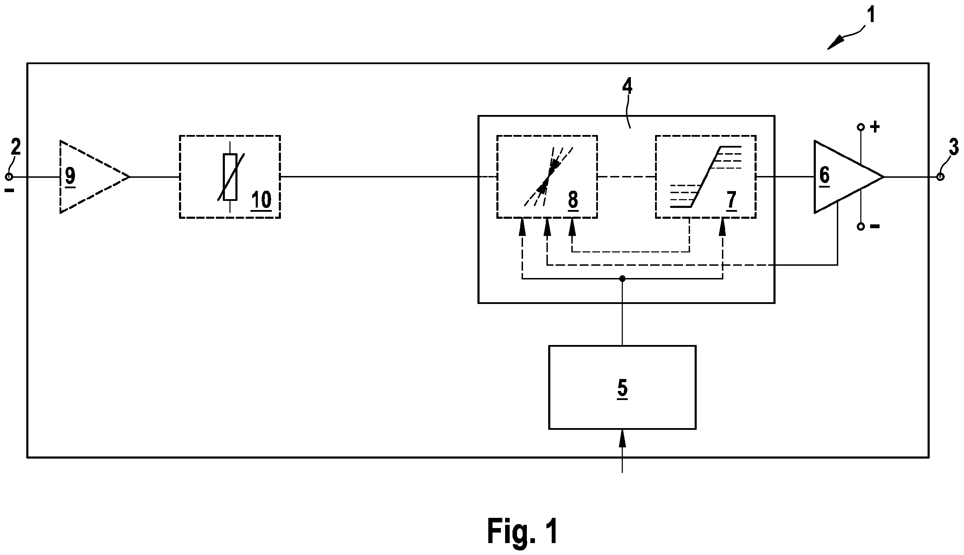

Die Figur 1 zeigt in einem schematischen Blockdiagramm einen Audioverstärker 1, welcher zur Verstärkung eines Eingangssignals, das an einer Eingangsschnittstelle 2 anliegt, zu einem Ausgangssignal, welches an einer Ausgangsschnittstelle 3 anliegt, ausgebildet ist. Derartige Audioverstärker 1 werden beispielsweise in Beschallungsanlagen (z.B. Public Address Systems) oder in Musikverstärkern eingesetzt. Der Audioverstärker 1 ist so realisiert, dass an der Ausgangsschnittstelle 3 ein Ausgangssignal für Lautsprechersysteme (nicht gezeigt) mit verschiedenen Lastimpedanzen mit einstellbarer Maximalleistung ausgegeben werden kann. Für die Anpassung wird die Lastimpedanz und die gewünschte Maximalleistung manuell eingestellt und/oder automatisch erfasst. Statt des Parametersatzes Lastimpedanz-Maximalleistung kann auch ein äquivalenter Parametersatz verwendet werden. Auf Basis des Parametersatzes wird der Audioverstärker 1 intern so angesteuert, dass die Maximalleistung bei der entsprechenden Lastimpedanz nicht überschritten wird.

In dem Blockdiagramm sind die wichtigsten Bestandteile mit durchgezogener Linie dargestellt, die optionalen Bestandteile des Audioverstärkers 1 sind gestrichelt illustriert. Ausgehend von der Eingangsschnittstelle 2 wird das Eingangssignal optional über weitere Funktionsbaugruppen - im Ursprungszustand bzw. im bearbeiteten Zustand auch als Audioträgersignal bezeichnet - zu einer Begrenzereinrichtung 4 geleitet, welche in Abhängigkeit eines Steuerungssignals einer Steuereinheit 5 das Audioträgersignal über bzw. auf einen Maximalpegel begrenzt und als begrenztes Zwischensignal an eine Ausgangsverstärkerstufe 6 weitergibt.

Ein Gedanke des Audioverstärkers 1 liegt darin, dass die maximale Ausgangsspannung an der Ausgangsschnittstelle 3 nicht durch die Höhe einer internen Versorgungsspannung des Audioverstärkers 1, sondern durch die Begrenzung des Zwischensignals im Kleinsignalbereich bestimmt wird. Die Versorgungsspannung wird so gewählt, dass die Ausgangsverstärkerstufe 6 die gewünschte maximale Ausgangsleistung in die höchste gewünschte Lastimpedanz abgeben kann. Wenn der Audioverstärker 1 beispielsweise ausgelegt sein soll, 1000 Watt an eine Lastimpedanz von 8 Ohm abzugeben, muss die effektive Versorgungsspannung 126,5 V betragen, wobei in der Praxis aufgrund von Spannungsabfällen an realen Bauteilen eine etwas höhere Spannung benötigt wird. Wenn der Audioverstärker 1 die gleiche Ausgangsleistung an eine niedrige Lastimpedanz abgeben soll und/oder weniger als die Maximalleistung abgeben soll, ist es bei dem vorliegenden Audioverstärker 1 nicht notwendig, die Höhe der inneren Versorgungsspannung zu variieren, sondern die Begrenzung der Ausgangsspannung und damit der Ausgangsleistung wird durch die Begrenzung des Zwischensignals mittels der Begrenzereinrichtung 4 im Kleinsignalbereich erreicht. Die Clipgrenze in der Begrenzungseinrichtung 4 wird dabei so eingestellt, dass die damit erreichbare maximale Ausgangsspannung an der Ausgangsschnittstelle 3 zur gewählten Konfiguration Ausgangsleistung - Lastimpedanz passt. Das Steuerungssignal der Steuereinheit 5 für die Begrenzereinrichtung 4 kann als ein Sollwert für einen Maximalpegel des Zwischensignals oder als die Parameter zur Bestimmung des Maximalpegels ausgebildet sein.

Die Ausgangsverstärkerstufe 6 ist als ein Class-D-Verstärker ausgebildet. Der Class-D-Verstärker arbeitet in einem Schaltbetrieb, wobei der Wirkungsgrad theoretisch 100 %, praktisch durch Umschalt- und Leitendverluste einen Wirkungsgrad um die 90 % erzielt. Ein Class-D-Verstärker kann in einer beispielhaften Ausführung in drei Bereiche unterteilt werden, wobei der erste Bereich den Eingang für das Zwischensignal, einen Dreiecks-Signal-Generator und einen Komparator, der zweite Bereich eine Schalt-Verstärkungsstufe und der dritte Bereich einen Tiefpassfilter umfasst.

In dem ersten Bereich wird das durch den Signalgenerator erzeugte vorzugsweise dreiecksförmige Signal durch das Zwischensignal moduliert, wobei der Komparator die Spannungswerte des Zwischensignals mit dem des Signals des Signalgenerators vergleicht und dann seinen Ausgang an- oder abschaltet, abhängig davon, welches der beiden Signale gerade eine höhere Spannung aufweist. Der erste Bereich stellt somit eine Puls-Weiten-Modulation (PWM) dar, welche als Ausgangssignal ein Rechtecksignal mit der gleichen Frequenz wie das Signal des Signalgenerators, jedoch mit unterschiedlich breiten Rechtecken, den Pulsbreiten, bereitstellt. Letztere bilden die Informationen über Amplitude und Frequenz des Audiosignals ab. In dem zweiten Bereich wird das PWM-Signal beispielsweise durch Transistoren verstärkt, wobei die Transistoren voll durchgeschaltet bzw. abgeschaltet sind, sie sind somit entweder ein- oder ausgeschaltet, woran auch der Grund für die hohe Effizienz dieses Schaltungsdesigns liegt. In dem dritten Bereich wird das durch den Signalgenerator erzeugtes Trägersignal ausgefiltert, wobei üblicherweise ein passives LC-Filter verwendet wird. Der Class-D-Verstärker kann aufgrund des internen Aufbaus und der Unabhängigkeit des Wirkungsgrades von der Aussteuerung auch in einem Ausgangsspannungsbereich betrieben werden, der nur einen Bruchteil der tatsächlich zur Verfügung stehenden Betriebsspannung entspricht. Nebenbei sei bemerkt, dass die vorliegende Erfindung sich nicht auf eine bestimmte Topologie eines Class-D-Verstärkers beschränkt und insbesondere nicht an ein bestimmtes Modulations- oder Rückkopplungsschema des Class-D-Verstärkers gebunden ist.

Durch die über die Steuereinheit 5 einstellbare oder ansteuerbare Begrenzungseinrichtung 4 findet eine symmetrische Begrenzung des Audioträgersignals statt, so dass an der nachfolgenden Ausgangsverstärkerstufe 6 ein auf einen Maximalpegel begrenztes Zwischensignal anliegt.

Da der nachfolgende Class-D-Verstärker eine konstante Verstärkung hat und aufgrund der gewählten Höhe der Versorgungsspannung immer im linearen Bereich arbeitet, verhält sich der gesamte Audioverstärker 1 von außen betrachtet wie ein herkömmlicher Verstärker, bei dem die interne Versorgungsspannung virtuell stufenlos eingestellt werden kann.

Die Begrenzungseinrichtung 4 kann in einer möglichen Ausführungsform wie in der Figur 1 dargestellt aus einer Analysatoreinheit 7 und einer Limitereinheit 8 ausgebildet sein. Funktionell betrachtet analysiert die Analysatoreinheit 7 das anliegende Audioträgersignal und gibt ein Begrenzungssignal an die Limitereinheit 8 aus, so dass diese das Audioträgersignal angepasst verstärken bzw. dämpfen kann. Optional begrenzt auch die Analysatoreinheit 7 den Tastgrad (Duty Cycle) des Audioträgersignals.

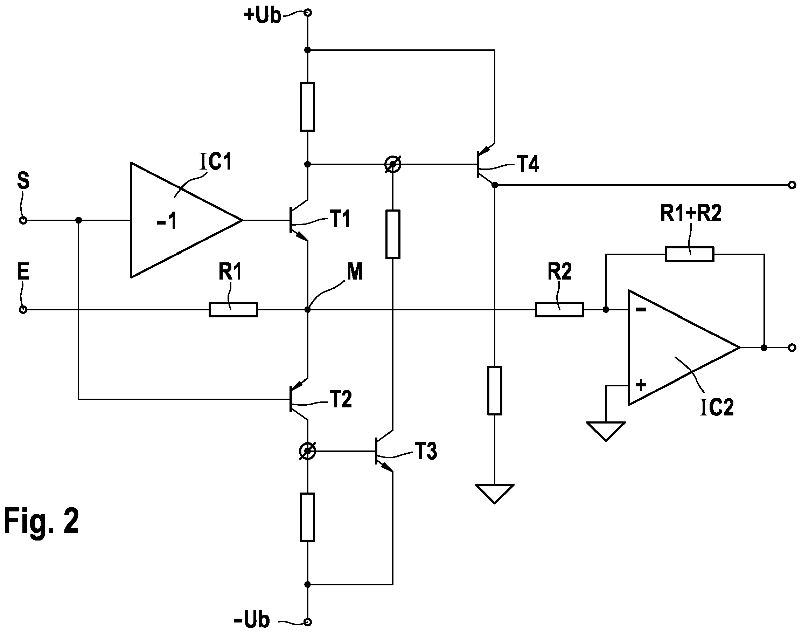

Eine mögliche Realisierung der Analysatoreinheit 7 ist in der Figur 2 in einem schematischen Stromlaufplan dargestellt. Das Audioträgersignal wird der Analysatoreinheit 7 an einem Eingang E über einen Widerstand R 1 zugeführt. Der Widerstand R 1 bildet mit einem Widerstand R 2 einen Spannungsteiler. Der gemeinsame Mittelpunkt M dieses Spannungsteilers ist als Knoten zugleich an die Emitter von Transistoren T1 und T2 angeschlossen, wobei die Signalbegrenzung durch die beiden Transistoren T1 und T2 erfolgt. Wenn diese im Sperrzustand sind, fließt der Strom des Audioträgersignals durch den Widerstand R1 auf einen negativen Eingang eines Operationsverstärkers IC 2, der auf virtueller Masse liegt. Da der Operationsverstärker IC2 mit R1 plus R2 gegengekoppelt ist, ist die Verstärkung des Begrenzers null dB. Der Einsatzbereich der Begrenzungseinrichtung 4 wird durch eine positive Steuerspannung aus der Steuereinheit 5 vorgegeben, die an dem Eingang S anliegt. Um eine symmetrische Signalbegrenzung zu erreichen, wird das Steuersignal S mithilfe von einem Operationsverstärker IC1 invertiert. Das invertierte Steuersignal wird der Basis von T1, das nicht invertierten Steuersignal der Basis von T2 zugeführt. Überschreitet das Audioträgersignal am Mittelpunkt des Spannungsteilers R1 und R2 die Steuerspannung um die Basis-Mitte-Flussspannung, wird T2 leiten. T2 klammert dadurch den Eingangspegel im positiven Spannungsbereich auf die Höhe der Steuerspannung plus eine Diodenstrecke. Auf gleiche Weise klammert T1 das Eingangssignal im negativen Spannungsbereich. Auf diese Weise erfolgt durch die Wahl der Steuerspannung eine symmetrische Signalbegrenzung des Ansteuersignals der folgenden Ausgangsverstärkerstufe 6. Die beiden Transistoren T3 und T4 sind nur nötig, wenn die Limitereinheit 8 vorhanden ist. Diese Transistoren T3 und T4 stellen im Falle der einsetzenden Signalbegrenzung in der Analysatoreinheit 7 der Limitereinheit 8 ein Ansteuersignal zur Verfügung. Dieses Ansteuersignal ist im Ruhezustand 0 Volt, bei einsetzender Signalbegrenzung geht es auf plus UB, da T4 leitend wird. Durch diesen Regelkreis kommt es nicht zu einem harten Clippen des Audiosignals in der Begrenzereinrichtung 4, sondern die vorgeschaltete Limitereinheit 8 reduziert entsprechend die Verstärkung bis die Einsatzgrenze der Begrenzung durch die Analysatoreinheit 7 gerade erreicht ist.

Als weitere Funktionsblöcke weist der Audioverstärker 1 optional die folgenden Komponenten auf: Eine Eingangsverstärkungseinrichtung 9 nimmt die impedanz- und pegelmäßige Anpassung des Eingangssignals an die nachfolgenden Stufen des Audioverstärkers 1 vor. Für einen Verstärker gemäß dieser Erfindung ist es dabei unerheblich, ob der Eingangsverstärker für symmetrische oder unsymmetrische Eingangssignale konstruiert wurde. Ein Levelsteller 10 dient der Lautstärke- und Verstärkungsanpassung. Der Levelsteller 10 ist für die Funktion des Audioverstärkers 1 nicht unbedingt notwendig und kann optional auch entfallen. Die Limitereinheit 8 stellt als optional ergänzende Funktion sicher, dass die Verzerrungen des Ausgangssignals unter allen Umständen einen gewissen Prozentsatz (z.B. 1%) nicht überschreiten. Wenn der Audioverstärker 1 seinen linearen Bereich verlassen müsste, z.B. bei Erreichen der Betriebsspannungsgrenze oder bei einer Begrenzung durch die Analysatoreinheit 7 nimmt die Limitereinheit 8 die Verstärkung soweit zurück, dass die entstehenden Verzerrungen des Ausgangssignals beschränkt bleiben. Bei einer alternativen Betriebsart kann es auch sinnvoll sein, dass die Steuereinheit 5 eine Verstärkungsanpassung des gesamten Audioverstärkers 1 in der Limitereinheit 8 durchführt.

Hinsichtlich des Aufbaus des Audioverstärkers 1 kann die Steuereinheit 5 diskret aufgebaut sein oder durch eine integrierte Schaltung wie eine Mikrokontrollerschaltung realisiert sein. Vorstellbar ist auch, dass die Steuereinheit 5 in ein externes Gerät ausgelagert ist und signaltechnisch kabelgebunden oder kabellos die Ansteuersignale für die Begrenzungseinrichtung 4 übergeben werden.

## Patentansprüche

1. Audioverstärker (1) zur Verstärkung eines Eingangssignals in ein Ausgangssignal mit einer Ausgangsverstärkerstufe (6), wobei die Ausgangsverstärkerstufe (6) zur Verstärkung eines Zwischensignals in das Ausgangssignal als ein im Schaltbetrieb arbeitender Verstärker ausgebildet ist, mit einer Begrenzereinrichtung (4), wobei die Begrenzereinrichtung (4) programmtechnisch und/oder schaltungstechnisch ausgebildet ist, in Abhängigkeit eines Steuerungssignals einer Steuereinheit (5) ein Audioträgersignal über bzw. auf einen Maximalpegel zu begrenzen und als begrenztes Zwischensignal an die Ausgangsverstärkerstufe (6) weiterzugeben, wobei das Audioträgersignal das Eingangssignal im Ursprungszustand oder in einem bearbeiteten Zustand ist, und

   der Audioverstärker (1) die Steuereinheit (5) zur Steuerung der Begrenzereinrichtung (4), und eine Übergabeeinrichtung, welche zur manuellen Eingabe der an dem Audioverstärker (1) anliegenden Lastimpedanz und einer stellbaren Maximalleistung ausgebildet ist, enthält

   wobei die Übergabeeinrichtung zur Übergabe der anliegenden Lastimpedanz und der stellbaren Maximalleistung an die Steuereinheit (5) ausgebildet ist, wobei das Steuerungssignal als ein Sollwert für den Maximalpegel des Zwischensignals oder als Parameter zur Bestimmung des Maximalpegels ausgebildet ist und der Pegel des Zwischensignals in Abhängigkeit der stellbaren Maximalleistung und der an den Audioverstärker angekoppelten Lastimpedanz stets derart durch den Maximalpegel begrenzt ist, dass das Ausgangssignal unabhängig vom Eingangssignal die stellbare Maximalleistung bei der Lastimpedanz nicht überschreitet.

2. Audioverstärker (1) nach Anspruch 1, wobei die Ausgangsverstärkerstufe (6) mit einer einzigen bipolaren Spannungsversorgung versorgt ist und/oder die Ausgangsverstärkerstufe als ein Class-D Verstärker und/oder mit einer konstanten Verstärkung ausgebildet ist.

3. Audioverstärker (1) nach Anspruch 1 oder 2, wobei die Begrenzereinrichtung (4) eine Analysatoreinheit (7) und eine Limitereinheit (8) aufweist, wobei die Analysatoreinheit (7) auf Basis eines anliegenden Audioträgersignals, welches als das Eingangssignal ausgebildet ist, ein Begrenzungssignal an die Limitereinheit (8) ausgibt und/oder rückkoppelt.

4. Audioverstärker (1) nach Anspruch 3, wobei die Limitereinheit (7) als eine Vorverstärkungs- und/oder eine Dämpfungseinrichtung ausgebildet ist.

5. Audioverstärker (1) nach einem der vorhergehenden Ansprüche, mit einer Levelstellereinrichtung (10) zur Lautstärke und/oder Verstärkungsanpassung des Audioverstärkers (1).

6. Audioverstärker (1) nach einem der vorhergehenden Ansprüche, mit einer Mehrzahl von Kanälen, wobei jeder Kanal eine Ausgangsverstärkerstufe (6) und eine zugeordnete Begrenzereinrichtung (4) aufweist.

**Claims**

1. Audio amplifier (1) for amplifying an input signal to produce an output signal, having an output amplifier stage (6), wherein the output amplifier stage (6) is configured to amplify an intermediate signal to produce the output signal as an amplifier operating in switched mode, having a limiter device (4), wherein the limiter device (4) is configured by programming and/or circuitry to take a control signal from a control unit (5) as a basis for limiting an audio carrier signal above or to a maximum level and to forward said audio carrier signal as a limited intermediate signal to the output amplifier stage (6), wherein the audio carrier signal is the input signal in the original state or in a processed state, and the audio amplifier (1) contains the control unit (5) for controlling the limiter device (4), and
a transfer device configured for manual input of the load impedance present on the audio amplifier (1) and of a settable maximum power,
wherein the transfer device is configured for transfer of the load impedance present and of the settable maximum power to the control unit (5),
wherein the control signal is configured as a setpoint value for the maximum level of the intermediate signal or as a parameter for determining the maximum level, and the level of the intermediate signal is always limited by the maximum level on the basis of the settable maximum power and the load impedance coupled to the audio amplifier such that the output signal does not exceed the settable maximum power at the load impedance regardless of the input signal.

2. Audio amplifier (1) according to Claim 1, wherein the output amplifier stage (6) is provided with a single bipolar power supply and/or the output amplifier stage is configured as a class-D amplifier and/or to have constant gain.

3. Audio amplifier (1) according to Claim 1 or 2, wherein the limiter device (4) has an analyser unit (7) and a limiter unit (8), wherein the analyser unit (7) outputs and/or feeds back a limiting signal to the limiter unit (8) on the basis of an applied audio carrier signal configured as the input signal.

4. Audio amplifier (1) according to Claim 3, wherein the limiter unit (7) is configured as a pre-amplification and/or attenuation device.

5. Audio amplifier (1) according to one of the preceding claims, having a level control device (10) for the volume and/or for gain adjustment of the audio amplifier (1).

6. Audio amplifier (1) according to one of the preceding claims, having a plurality of channels, wherein each channel has an output amplifier stage (6) and an associated limiter device (4).

**Revendications**

1. Amplificateur audio (1), destiné à amplifier un signal d'entrée en un signal de sortie, doté d'un étage amplificateur de sortie (6) pour amplifier un signal intermédiaire dans le signal de sortie, l'étage amplificateur de sortie (6) étant conçu sous la forme d'un amplificateur travaillant en mode de commutation, doté d'un dispositif limiteur (4),
le dispositif limiteur (4) étant conçu au niveau de la technique du programme et/ou au niveau de la technique de commutation pour limiter, en fonction d'un signal de commande d'une unité de commande (5) un signal porteur audio au-delà de ou à un niveau maximal et à le retransmettre en tant que signal intermédiaire limité à l'étage amplificateur de sortie (6), le signal porteur audio étant le signal d'entrée à l'état initial ou dans un état traité et l'amplificateur audio (1) contenant l'unité de commande (5) destinée à commander le dispositif limiteur (4) et un dispositif de transmission, lequel est conçu pour l'entrée manuelle de l'impédance de charge appliquée sur l'amplificateur audio (1) et d'une puissance maximale réglable,
le dispositif de transmission étant conçu pour transmettre l'impédance de charge appliquée et la puissance maximale réglable à l'unité de commande (5),
le signal de commande étant conçu sous la forme d'une valeur de consigne pour le niveau maximal du signal intermédiaire ou sous la forme d'un paramètre destiné à déterminer le niveau maximal et le niveau du signal intermédiaire étant toujours limité par le niveau maximal, en fonction de la puissance maximale réglable et de l'impédance de charge couplée sur l'amplificateur audio, de telle sorte qu'indépendamment du signal d'entrée, le signal de sortie ne dépasse pas la puissance maximale réglable, sous l'impédance de charge.

2. Amplificateur audio (1) selon la revendication 1, l'étage amplificateur de sortie (6) étant alimenté à l'aide d'une unique alimentation en tension bipolaire et/ou l'étage amplificateur de sortie étant conçu sous la forme d'un amplificateur de classe D et/ou avec une amplification constante.

3. Amplificateur audio (1) selon la revendication 1 ou 2, le dispositif limiteur (4) comportant une unité d'analyse (7) et une unité de limitation (8), sur la base d'un signal porteur audio appliqué, lequel est conçu comme étant le signal d'entrée, l'unité d'analyse (7) délivrant et/ou réinjectant un signal de limitation à l'unité de limitation (8).

4. Amplificateur audio (1) selon la revendication 3, l'unité de limitation (7) étant conçue sous la forme d'un dispositif préamplificateur et/ou d'un dispositif atténuateur.

5. Amplificateur audio (1) selon l'une quelconque des revendications précédentes, doté d'un dispositif de réglage du niveau (10) pour le niveau sonore et/ou d'une adaptation d'amplification de l'amplificateur audio (1).

6. Amplificateur audio (1) selon l'une quelconque des revendications précédentes, doté d'une pluralité de canaux, chaque canal comportant un étage amplificateur de sortie (6) et un dispositif limiteur (4) associé.

Fig. 1

EP 2 332 252 B1

Fig. 2

10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2004023631 A
- EP 0762633 A1